(19)

Europäisches
Patentamt
European
Patent Office
Office européen
des brevets

(11) **EP 3 174 196 A1**

(12) **EUROPEAN PATENT APPLICATION**
published in accordance with Art. 153(4) EPC

(43) Date of publication:
**31.05.2017 Bulletin 2017/22**

(21) Application number: **15874865.7**

(22) Date of filing: **06.08.2015**

(51) Int Cl.:
**H02S 10/00** (2014.01)

(86) International application number:
**PCT/CN2015/086244**

(87) International publication number:
**WO 2016/107176 (07.07.2016 Gazette 2016/27)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **04.01.2015 CN 201510003630**

(71) Applicant: **Huawei Technologies Co. Ltd.
Shenzhen, Guangdong 518129 (CN)**

(72) Inventors:
- SHI, Lei
  **Shenzhen
  Guangdong 518129 (CN)**
- YE, Fei
  **Shenzhen
  Guangdong 518129 (CN)**
- LIU, Yunfeng
  **Shenzhen
  Guangdong 518129 (CN)**

(74) Representative: **Körber, Martin Hans
Mitscherlich PartmbB
Patent- und Rechtsanwälte
Sonnenstrasse 33
80331 München (DE)**

(54) **PHOTOVOLTAIC SYSTEM**

(57) Embodiments of the present invention disclose a photovoltaic system, including multiple photovoltaic cell strings, a converter, a controller, and a bus, where the multiple photovoltaic cell strings include at least one string group in which two or three parallel-connected photovoltaic cell strings are connected to one current sensor, where the at least one string group, after being connected in parallel, is connected to the converter by using the bus, and the controller is connected to a current sensor in each string group in the at least one string group, the current sensor is configured to detect a total current of each string group, and report whether a reverse current exists in each string group to the controller, the controller is configured to adjust, when receiving a report from the current sensor that a reverse current exists in a target string group in the at least one string group, a control signal output to the converter, and the converter is configured to decrease, according to an adjusted control signal, a system voltage between the buses to decrease the reverse current in the target string group. Therefore, not only photovoltaic cell protection can be provided, but also a device cost is decreased.

FIG. 1

Printed by Jouve, 75001 PARIS (FR)

## Description

## TECHNICAL FIELD

The present invention relates to the field of electronic technologies, and in particular, to a photovoltaic system.

## BACKGROUND

In an application scenario of a photovoltaic inverter, photovoltaic cells are connected in series or in parallel to provide an output voltage and an output current for a load. However, if one photovoltaic cell string is short-circuited, other photovoltaic cell strings may be caused to feed a reverse current to the short-circuited photovoltaic cell string. If the reverse current is higher than a short circuit current of a photovoltaic cell, it may be caused that the faulty photovoltaic cell string is burned, or in a severe case, a fire hazard may occur. Therefore, for a photovoltaic cell string, a corresponding protective measure needs to be added to prevent occurrence of a major accident.

In a solution of the prior art, each photovoltaic cell string is connected to a current sensor, and each current sensor detects a current of each photovoltaic cell string in real time. When a current sensor detects that a reverse current exists in a photovoltaic cell string, the current sensor reports the reverse current to a controller, and the controller controls a converter to decrease the reverse current of the photovoltaic cell string to protect photovoltaic cells. However, in the technical solution, each photovoltaic cell string needs to be connected to a current sensor, resulting in an increase of a device cost.

## SUMMARY

The present invention provides a photovoltaic system, which can not only provide photovoltaic cell protection, but also decrease a device cost.

A first aspect of the present invention provides a photovoltaic system, including multiple photovoltaic cell strings, a converter, a controller, and a bus, where the multiple photovoltaic cell strings include at least one string group in which two or three parallel-connected photovoltaic cell strings are connected to one current sensor, where the at least one string group, after being connected in parallel, is connected to the converter by using the bus, the converter is connected to the controller, and the controller is connected to a current sensor in each string group in the at least one string group, the current sensor is configured to detect a total current of each string group, and report whether a reverse current exists in each string group to the controller, the controller is configured to adjust, when receiving a report from the current sensor that a reverse current exists in a target string group in the at least one string group, a control signal output to the converter, and the converter is configured to decrease, according to the adjusted control signal, a system voltage between the buses to decrease the reverse current in the target string group.

In a first possible implementation manner of the first aspect, the multiple photovoltaic cell strings further include a string group in which one photovoltaic cell string is connected to one current sensor, where the string group in which one photovoltaic cell string is connected to one current sensor and the at least one string group in which two or three parallel-connected photovoltaic cell strings are connected to one current sensor, after being connected in parallel, are connected to the converter by using the bus, and the current sensor in the string group in which one photovoltaic string is connected to one current sensor is connected to the controller.

In a second possible implementation manner of the first aspect, the converter includes a switching transistor, a first capacitor, an inductor, and a first diode, where:

one end of the inductor is connected to an input end of the converter, the other end of the inductor is connected to both a collector of the switching transistor and a positive electrode of the first diode, a negative electrode of the first diode is connected to one end of the first capacitor, and the other end of the first capacitor is connected to both an emitter of the switching transistor and an output end of the converter.

In a third possible implementation manner of the first aspect, the controller includes a processor and a driver, where:

the processor is configured to determine whether the reverse current in the target string group is higher than the preset threshold; and
the driver is connected to the processor, and configured to adjust, when the processor determines that the reverse current in the target string group is higher than the preset threshold, the control signal output to the converter.

With reference to the third possible implementation manner of the first aspect, in a fourth possible implementation manner of the first aspect, the controller further includes an analog to digital converter, where the analog to digital converter is connected to the processor, and configured to convert an analog signal of the reverse current reported by the current sensor into a digital signal of the reverse current, and output the digital signal of the reverse current to the processor.

With reference to the second possible implementation manner of the first aspect, in a fifth possible implementation manner of the first aspect, the converter further includes a second capacitor, where one end of the second capacitor is connected to one end of the inductor, the other end of the second capacitor is connected to the emitter of the switching transistor, and the second capacitor is configured to perform filtering processing on the input voltage.

In implementation of the present invention, a photovoltaic system includes multiple photovoltaic cell strings, a converter, a controller, and a bus, where the multiple photovoltaic cell strings include at least one string group in which two or three parallel-connected photovoltaic cell strings are connected to one current sensor, where the at least one string group, after being connected in parallel, is connected to the converter by using the bus, the converter is connected to the controller, and the controller is connected to a current sensor in each string group in the at least one string group, where the current sensor is configured to detect a total current of each string group, and report whether a reverse current exists in each string group to the controller, the controller is configured to adjust, when receiving a report from the current sensor that a reverse current exists in a target string group in the at least one string group, a control signal output to the converter, and the converter is configured to decrease, according to an adjusted control signal, a system voltage between the buses to decrease the reverse current in the target string group. Therefore, not only photovoltaic cell protection can be provided, but also a device cost is decreased.

**BRIEF DESCRIPTION OF DRAWINGS**

To describe the technical solutions in the embodiments of the present invention more clearly, the following briefly introduces the accompanying drawings required for describing the embodiments. Apparently, the accompanying drawings in the following description show some embodiments of the present invention, and a person of ordinary skill in the art may still derive other drawings from these accompanying drawings without creative efforts.

FIG. 1 is a schematic structural diagram of a photovoltaic system according to an embodiment of the present invention;
FIG. 2 is a schematic structural diagram of a converter in a photovoltaic system according to an embodiment of the present invention;
FIG. 3 is a schematic structural diagram of a controller in a photovoltaic system according to an embodiment of the present invention; and
FIG. 4 is a V-I curve chart in working of photovoltaic cell strings.

**DESCRIPTION OF EMBODIMENTS**

The following clearly and completely describes the technical solutions in the embodiments of the present invention with reference to the accompanying drawings in the embodiments of the present invention. Apparently, the described embodiments are some but not all of the embodiments of the present invention. All other embodiments obtained by a person of ordinary skill in the art based on the embodiments of the present invention without creative efforts shall fall within the protection scope of the present invention.

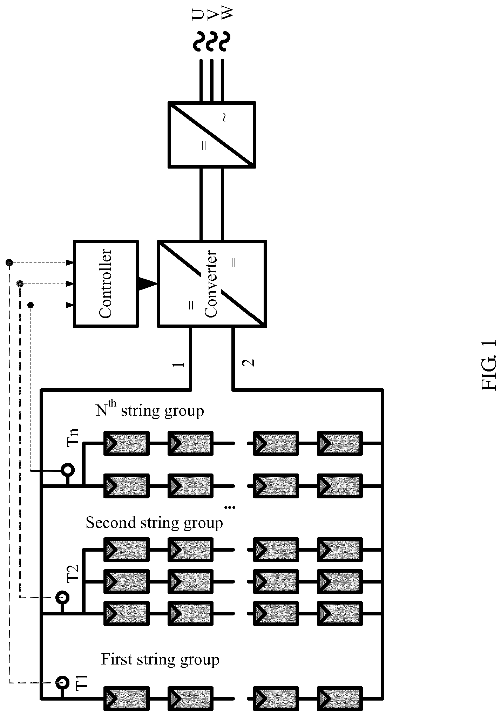

Referring to FIG. 1, FIG. 1 is a schematic structural diagram of a photovoltaic system according to an embodiment of the present invention. As shown in FIG. 1, the photovoltaic system includes multiple photovoltaic cell strings, a converter, a controller, and a bus, where the multiple photovoltaic cell strings include at least one string group in which two or three parallel-connected photovoltaic cell strings are connected to one current sensor, where the at least one string group, after being connected in parallel, is connected to the converter by using buses (1, 2), the converter is connected to the controller, and the controller is connected to a current sensor in each string group in the at least one string group, the current sensor is configured to detect a total current of each string group, and report whether a reverse current exists in each string group to the controller, the controller is configured to adjust, when receiving a report from the current sensor that a reverse current exists in a target string group in the at least one string group, a control signal output to the converter, and the converter is configured to decrease, according to the adjusted control signal, a system voltage between the buses (1, 2) to decrease the reverse current in the target string group.

Optionally, the multiple photovoltaic cell strings further include a string group in which one photovoltaic cell string is connected to one current sensor, where the string group in which one photovoltaic cell string is connected to one current sensor and the at least one string group in which two or three parallel-connected photovoltaic cell strings are connected to one current sensor, after being connected in parallel, are connected to the converter by using the buses (1, 2), and the current sensor in the string group in which one photovoltaic string is connected to one current sensor is connected to the controller.

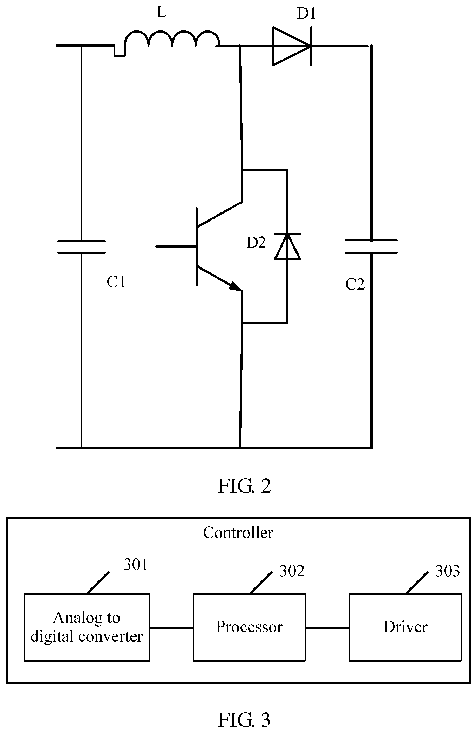

Optionally, as shown in FIG. 2, the converter includes a switching transistor, a first capacitor C1, an inductor L, and a first diode D1, where one end of the inductor L is connected to an input end of the converter, the other end of the inductor L is connected to both a collector of the switching transistor and a positive electrode of the first diode D1, a negative electrode of the first diode D1 is connected to one end of the first capacitor C1, and the other end of the first capacitor C1 is connected to both an emitter of the switching transistor and an output end of the converter.

Further, optionally, the converter further includes a second capacitor C2, where one end of the second capacitor C2 is connected to one end of the inductor L, the other end of the second capacitor C2 is connected to the emitter of the switching transistor, and the second capacitor C2 is configured to perform filtering processing on an input voltage.

Optionally, as shown in FIG. 3, the controller includes a processor 302 and a driver 303.

The processor 302 is configured to determine whether the reverse current in the target string group is higher than the preset threshold.

The driver 303 is connected to the processor, and configured to adjust, when the processor determines that the reverse current in the target string group is higher than the preset threshold, the control signal output to the converter.

Further, optionally, the controller further includes an analog to digital converter 301, where the analog to digital converter 301 is connected to the processor 302, and configured to convert an analog signal of the reverse current reported by the current sensor into a digital signal of the reverse current, and output the digital signal of the reverse current to the processor.

In this embodiment of the present invention, when the string group in which the reverse current exists includes one photovoltaic cell string, the controller adjusts the control signal output to the converter, and the converter decreases, according to the adjusted control signal, the system voltage between the buses (1, 2), to decrease the reverse current of the string group to lower than a short circuit current of a photovoltaic cell. When the string group in which the reverse current exists includes two or more photovoltaic cell strings, the controller adjusts the control signal output to the converter, and the converter decreases, according to the adjusted control signal, the system voltage between the buses (1, 2), to decrease the reverse current of the string group to 0.

For example, as shown in FIG. 1, the photovoltaic system includes n string groups, and the n string groups include m photovoltaic cell strings, where a first string group includes one photovoltaic cell string, a second string group includes three photovoltaic cell strings, and an $n^{th}$ string group includes two photovoltaic cell strings. When a photovoltaic cell string 1 in the first string group is short-circuited, output currents of another photovoltaic cell string 2 to a photovoltaic cell string m are all a maximum current value $I_{sc}$, causing the photovoltaic cell string 2 to the photovoltaic cell string m to feed a reverse current (m-1) $I_{sc}$ to the photovoltaic cell string 1, and a current sensor T1 detects that the reverse current exists in the first string group and that a current value of the reverse current is (m-1) $I_{sc}$. Alternatively, when a photovoltaic cell string 1 in the second string group is short-circuited, output currents of a photovoltaic cell string 2 to a photovoltaic cell string m are all a maximum current value $I_{sc}$, causing the photovoltaic cell string 2 to the photovoltaic cell string m to feed a reverse current (m-1) $I_{sc}$ to the photovoltaic cell string 1, and in this case, a current sensor T2 detects that the reverse current exists in the second string group and that a current value of the reverse current is (m-3) $I_{sc}$. Alternatively, when a photovoltaic cell string 1 in the $n^{th}$ string group is short-circuited, output currents of a photovoltaic cell string 2 to a photovoltaic cell string m are all a maximum current value $I_{sc}$,

causing the photovoltaic cell string 2 to the photovoltaic cell string m to feed a reverse current (m-1) $I_{sc}$ to the photovoltaic cell string 1, and in this case, a current sensor Tn detects that the reverse current exists in the second string group and that a current value of the reverse current is (m-2) $I_{sc}$.

In this case, the current sensor reports the reverse current to the controller. When the controller determines that the reverse current is higher than a preset threshold, the controller increases an output time of a high electrical level in each switching cycle to increase a duty cycle D of a control signal, and outputs, to the converter, the control signal whose duty cycle is increased. As shown in FIG. 2, the converter is a switching direct current boost circuit. The switching direct current boost circuit controls turn-on of the switching transistor by controlling the duty cycle of the input control signal, so as to control an output voltage. In the switching direct current boost circuit, a relationship between an output voltage $v_{out}$ and an input voltage $v_{in}$ is $\frac{v_{out}}{v_{in}} = \frac{1}{1-D}$.

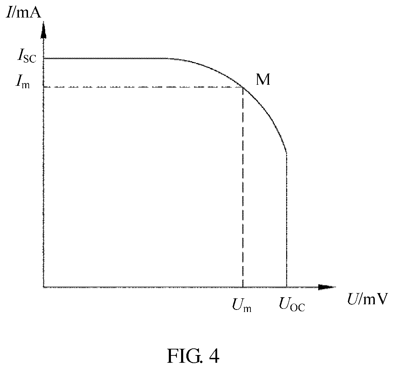

In a case in which a load is controlled to keep outputting a constant voltage $v_{out}$, an input voltage $v_{in}$ provided by a cell group string circuit may be decreased by increasing a duty cycle D of a control signal. According to a V-I curve chart, in working of photovoltaic cell strings, shown in FIG. 4, when the input voltage $v_{in}$ provided by the cell group string circuit decreases, an output current of the cell group string circuit increases, and in this case, output currents of the photovoltaic cell string 2 to the photovoltaic cell string m are all the maximum current value $I_{sc}$, and a forward current of the photovoltaic cell string 1 increases, causing the reverse current of the photovoltaic cell string 1 to decrease, until the reverse current of the photovoltaic cell string 1 is lower than the short circuit current of the photovoltaic cell or is 0, thereby protecting the photovoltaic cell string.

In this embodiment of the present invention, a photovoltaic system includes multiple photovoltaic cell strings, a converter, a controller, and a bus, where the multiple photovoltaic cell strings include at least one string group in which two or three parallel-connected photovoltaic cell strings are connected to one current sensor, where the at least one string group, after being connected in parallel, is connected to the converter by using the bus, the converter is connected to the controller, and the controller is connected to a current sensor in each string group in the at least one string group, the current sensor is configured to detect a total current of each string group, and report whether a reverse current exists in each string group to the controller, the controller is configured to adjust, when receiving a report from the current sensor that a reverse current exists in a target string group in the at least one string group, a control signal output to the converter, and the converter is configured to decrease, according to an adjusted control signal, a system voltage between the buses to decrease the reverse current in the target string group. Therefore, not only photovoltaic cell protection can be provided, but also a device cost is decreased.

It should be noted that, for brief description, the foregoing method embodiments are represented as a series of actions. However, a person skilled in the art should appreciate that the present invention is not limited to the described order of the actions, because according to the present invention, some steps may be performed in other orders or simultaneously. In addition, a person skilled in the art should also understand that all the embodiments described in this specification belong to exemplary embodiments, and the involved actions and modules are not necessarily mandatory to the present invention.

In the foregoing embodiments, the description of each embodiment has respective focuses. For a part that is not described in detail in an embodiment, reference may be made to related descriptions in other embodiments.

A person of ordinary skill in the art may understand that all or a part of the steps of the methods in the embodiments may be implemented by a program instructing relevant hardware. The program may be stored in a computer-readable storage medium. The storage medium may include a flash memory, a read-only memory (Read-Only Memory in English, ROM for short), a random access memory (Random Access Memory in English, RAM for short), a magnetic disk, and an optical disc.

A content downloading method, a related device, and a system provided by the embodiments of the present invention are described in detail above. Although the principles and implementation manners of the present invention are described by using specific examples, the description of the embodiments is only intended to help understand the method and core idea of the present invention. In addition, with respect to the specific implementation manners and application scopes, modifications and variations may be made by a person of ordinary skill in the art according to the idea of the present invention. Therefore, content of the specification shall not be construed as a limitation on the present invention.

**Claims**

1. A photovoltaic system, wherein the photovoltaic system comprises multiple photovoltaic cell strings, a converter, a controller, and a bus, wherein the multiple photovoltaic cell strings comprise at least one string group in which two or three parallel-connected photovoltaic cell strings are connected to one current sensor, the at least one string group, after being connected in parallel, is connected to the converter by using the bus, the converter is connected to the controller, and the controller is connected to a current sensor in each string group in the at least one string group, the current sensor is configured to detect a total current of each string group, and report whether a reverse current exists in each string group to the controller, the controller is configured to adjust, when receiving a report from the current sensor that a reverse current exists in a target string group in the at least one string group, a control signal output to the converter, and the converter is configured to decrease, according to the adjusted control signal, a system voltage between the buses to decrease the reverse current in the target string group.

2. The photovoltaic system according to claim 1, wherein the multiple photovoltaic cell strings further comprise a string group in which one photovoltaic cell string is connected to one current sensor, wherein the string group in which one photovoltaic cell string is connected to one current sensor and the at least one string group in which two or three parallel-connected photovoltaic cell strings are connected to one current sensor, after being connected in parallel, are connected to the converter by using the bus, and the current sensor in the string group in which one photovoltaic string is connected to one current sensor is connected to the controller.

3. The photovoltaic system according to claim 1 or 2, wherein the converter comprises a switching transistor, a first capacitor, an inductor, and a first diode, wherein:

    one end of the inductor is connected to an input end of the converter, the other end of the inductor is connected to both a collector of the switching transistor and a positive electrode of the first diode, a negative electrode of the first diode is connected to one end of the first capacitor, and the other end of the first capacitor is connected to both an emitter of the switching transistor and an output end of the converter.

4. The photovoltaic system according to claim 1 or 2, wherein the controller comprises a processor and a driver, wherein:

    the processor is configured to determine whether the reverse current in the target string group is higher than the preset threshold; and the driver is connected to the processor, and configured to adjust, when the processor determines that the reverse current in the target string group is higher than the preset threshold, the control signal output to the converter.

5. The photovoltaic system according to claim 4, wherein the controller further comprises an analog to digital converter, wherein the analog to digital converter is connected to the processor, and configured to convert an analog signal of the reverse current reported by the current sensor into a digital signal of the reverse current, and output the digital signal of the reverse current to the processor.

6. The photovoltaic system according to claim 3, wherein the converter further comprises a second capacitor, wherein one end of the second capacitor is connected to one end of the inductor, the other end of the second capacitor is connected to the emitter of the switching transistor, and the second capacitor is configured to perform filtering processing on the input voltage.

FIG. 1

L    D1

C1    D2    C2

FIG. 2

Controller

301    302    303

| Analog to digital converter | Processor | Driver |

FIG. 3

FIG. 4

<div align="center">**INTERNATIONAL SEARCH REPORT**</div>

| International application No. |
| --- |
| **PCT/CN2015/086244** |

**A. CLASSIFICATION OF SUBJECT MATTER**

H02S 10/00 (2014.01) i

According to International Patent Classification (IPC) or to both national classification and IPC

**B. FIELDS SEARCHED**

Minimum documentation searched (classification system followed by classification symbols)

H02S/-

Documentation searched other than minimum documentation to the extent that such documents are included in the fields searched

Electronic data base consulted during the international search (name of data base and, where practicable, search terms used)

CNPAT, CNKI, WPI, EPODOC: bus, reverse current, string, photovoltaic, transformer, controller, bus conductors

**C. DOCUMENTS CONSIDERED TO BE RELEVANT**

| Category* | Citation of document, with indication, where appropriate, of the relevant passages | Relevant to claim No. |
| --- | --- | --- |
| X | CN 102484368 A (SMA SOLAR TECHNOLOGY AG), 30 May 2012 (30.05.2012), description, paragraphs 26-27, and figure 1 | 1, 2, 4, 5 |
| Y | CN 102484368 A (SMA SOLAR TECHNOLOGY AG), 30 May 2012 (30.05.2012), description, paragraphs 26-27, and figure 1 | 3, 6 |
| Y | CN 102769398 A (HEFEI UNIVERSITY OF TECHNOLOGY), 07 November 2012 (07.11.2012), description, paragraphs 17-21, and figure 2 | 3, 6 |
| A | CN 102782974 A (AMERICAN SUPERCONDUCTOR CORPORATION), 14 November 2012 (14.11.2012), the whole document | 1-6 |
| A | CN 104143835 A (SHENZHEN KSTAR SCIENCE AND TECHNOLOGY CO., LTD.), 12 November 2014 (12.11.2014), the whole document | 1-6 |
| A | WO 2007048421 A2 (CONERGY AG et al.), 03 May 2007 (03.05.2007), the whole document | 1-6 |

| ☐ Further documents are listed in the continuation of Box C. | ☒ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 25 September 2015 (25.09.2015) | **16 October 2015 (16.10.2015)** |
| Name and mailing address of the ISA/CN: State Intellectual Property Office of the P. R. China No. 6, Xitucheng Road, Jimenqiao Haidian District, Beijing 100088, China Facsimile No.: (86-10) 62019451 | Authorized officer **LI, Yan** Telephone No.: (86-10) **010-82245254** |

Form PCT/ISA/210 (second sheet) (July 2009)

## INTERNATIONAL SEARCH REPORT
### Information on patent family members

| International application No. |
| --- |
| **PCT/CN2015/086244** |

| Patent Documents referred in the Report | Publication Date | Patent Family | Publication Date |
| --- | --- | --- | --- |
| CN 102484368 A | 30 May 2012 | US 2012139347 A1 | 07 June 2012 |
| | | CN 102484368 B | 22 July 2015 |
| | | JP 2013501495 A | 10 January 2013 |
| | | AT 555531 T | 15 May 2012 |
| | | EP 2284973 B1 | 25 April 2012 |
| | | ES 2384426 T3 | 04 July 2012 |
| | | US 8749934 B2 | 10 June 2014 |
| | | WO 2011015476 A2 | 10 February 2011 |
| | | CA 2770056 A1 | 10 February 2011 |
| | | EP 2284973 A1 | 16 February 2011 |
| | | JP 5590475 B2 | 17 September 2014 |
| CN 102769398 A | 07 November 2012 | None | |
| CN 102782974 A | 14 November 2012 | CA 2780806 A1 | 03 June 2011 |
| | | AU 2010325064 A1 | 21 June 2012 |
| | | US 7989983 B2 | 02 August 2011 |
| | | EP 2504901 A2 | 03 October 2012 |
| | | WO 2011066081 A9 | 12 July 2012 |
| | | US 2010277002 A1 | 04 November 2010 |
| | | US 2012033468 A1 | 09 February 2012 |
| | | KR 20120086366 A | 02 August 2012 |
| | | WO 2011066081 A2 | 03 June 2011 |
| CN 104143835 A | 12 November 2014 | None | |
| WO 2007048421 A2 | 03 May 2007 | EP 2369709 A2 | 28 September 2011 |
| | | EP 1946418 A2 | 23 July 2008 |

Form PCT/ISA/210 (patent family annex) (July 2009)